# EUROPÄISCHE PATENTANMELDUNG

(11) **EP 4 838 775 A1**
(43) Veröffentlichungstag der Anmeldung: **11.11.2026**
(21) Anmeldenummer: 25175166.5
(22) Anmeldetag: 08.05.2025
(51) Int. Cl.: H02M 3/158, G01R 31/40

(54) **MESSVORRICHTUNG UND VERFAHREN ZUR FUNKTIONSÜBERPRÜFUNG EINER SCHALTWANDLERANORDNUNG**

(71) Anmelder: Elmos Semiconductor SE, 51379 Leverkusen (DE)
(72) Erfinder: Wagenknecht, Christian, 01219 Dresden (DE)
(74) Vertreter: Pearl Cohen EU

(57) **Zusammenfassung**

Bereitgestellt wird eine Messvorrichtung zur Funktionsüberprüfung einer Schaltwandleranordnung, dadurch gekennzeichnet, dass die Messvorrichtung dazu eingerichtet ist, eine Eingangsspannung und/oder eine Spannung an einem Schaltausgang der Schaltwandleranordnung und/oder eine Ausgangsspannung der Schaltwandleranordnung zu messen, unter Verwendung des zumindest einen Messwerts der Eingangsspannung, der Spannung am Schaltausgang und/oder der Ausgangsspannung ein Vorliegen eines Fehlerzustands der Schaltwandleranordnung zu ermitteln und ein Fehlersignal bereitzustellen, sofern das Vorliegen eines Fehlerzustands der Schaltwandleranordnung ermittelt wurde.

## Beschreibung

Die vorliegende Offenbarung betrifft eine Messvorrichtung zur Funktionsüberprüfung einer Schaltwandleranordnung und ein Verfahren zur Funktionsüberprüfung der Schaltwandleranordnung. Ferner wird ein integrierter Schaltkreis zur Verwendung in einer Schaltwandleranordnung bereitgestellt, der eine Messvorrichtung umfasst. Zusätzlich wird eine Schaltwandleranordnung bereitgestellt, die einen integrierten Schaltkreis mit einer Messvorrichtung umfasst. Die Offenbarung liegt somit insbesondere auf dem Gebiet der Schaltwandler.

Für manche Applikationen können Schaltwandler einen integrierten Schaltkreis mit einem Regler und einem oder mehreren elektronischen Schaltern sowie externe Bauteile aufweisen, wie z.B. ein oder mehrere Filterelemente und ein oder mehrere Dioden. Tritt ein Fehler in den externen Bauteilen auf, wie etwa ein Kurzschluss oder Leerlauf eines externen Bauelementes oder eine mangelhafte oder fehlende Kontaktierung des Reglereingangs, kann dies zu einer Fehlfunktion oder gar einer Beschädigung oder Zerstörung von Bauteilen durch Überspannung führen. Zur Begrenzung des Schadens dienen herkömmlicherweise Sicherheitsfunktionen, wie etwa eine Überstrombegrenzung im elektronischen Schalter. Das Vorsehen oder die Inanspruchnahme derartiger Sicherheitsfunktionen kann die Kosten für die Schaltwandler erhöhen oder zu Ausfällen von Bauteilen führen.

Es liegt die Aufgabe zugrunde, Verfahren und Vorrichtungen bereitzustellen, die die geschilderten Nachteile des Standes der Technik überwinden. Optional kann die Aufgabe darin liegen, eine Fehlfunktion und/oder eine Beschädigung eines Schaltwandlers und/oder damit verbundener Komponenten zu vermeiden.

Die Aufgabe wird gelöst durch eine Messvorrichtung, einen integrierten Schaltkreis, eine Schaltwandleranordnung und ein Verfahren mit den Merkmalen der jeweiligen unabhängigen Ansprüche. Optionale Ausgestaltungen sind in den Unteransprüchen und in der Beschreibung angegeben.

Bereitgestellt wird eine Messvorrichtung zur Funktionsüberprüfung einer Schaltwandleranordnung. Die Messvorrichtung ist dazu eingerichtet, eine Eingangsspannung und/oder eine Spannung an einem Schaltausgang der Schaltwandleranordnung und/oder eine Ausgangsspannung der Schaltwandleranordnung zu messen. Ferner ist die Messvorrichtung dazu eingerichtet, unter Verwendung des zumindest einen Messwerts der Eingangsspannung, der Spannung am Schaltausgang und/oder der Ausgangsspannung ein Vorliegen eines Fehlerzustands der Schaltwandleranordnung zu ermitteln. Darüber hinaus ist die Messvorrichtung dazu eingerichtet, ein Fehlersignal bereitzustellen, sofern das Vorliegen eines Fehlerzustands der Schaltwandleranordnung ermittelt wurde.

Eine Messvorrichtung ist dabei eine Vorrichtung, die dazu eingerichtet ist, Messungen vorzunehmen, anhand welcher ermittelbar ist, ob sich eine Schaltwandleranordnung in einem Fehlerzustand befindet oder nicht. Die Messvorrichtung kann optional eine elektrische oder elektronische Vorrichtung sein. Optional kann die Messvorrichtung in einen integrierten Schaltkreis integriert sein oder als solcher ausgebildet sein. Optional kann die Messvorrichtung zusammen mit anderen Komponenten in einen integrierten Schaltkreis integriert sein, wie etwa mit einem Regler und einem oder mehreren elektronischen Schaltern.

Ein Schaltwandleranordnung kann dabei eine Anordnung elektrischer und/oder elektronischer Komponenten sein, welche dazu ausgebildet ist, mittels eines oder mehrerer Schalter eine elektrische Spannung zu wandeln. Optional kann die Schaltwandleranordnung ein elektronisches Gerät oder eine Schaltung sein, die elektrische Energie mithilfe eines schnell schaltenden elektronischen Schalters und eines Energiespeichers (wie etwa einer Spule oder eines Kondensators) von einer Spannungs- oder Stromform in eine andere umwandelt. Optional kann die Schaltwandleranordnung als Abwärtswandler (engl. Buck Converter), als Aufwärtswandler (Boost Converter), als Inverswandler (Buck-Boost Converter) oder als eine Kombination solcher Wandler ausgebildet sein.

Ein Schaltausgang ist dabei ein Anschluss, an welchem ein Spannungssignal zur Durchführung eines Schaltvorgangs bereitgestellt wird.

Ein Messwert kann dabei als ein gemessener Spannungswert vorliegen, wobei der Messwert von der Messvorrichtung gemessen sein kann.

Ein Fehlersignal ist dabei ein Signal, welches das Vorliegen eines Fehlerzustands indiziert. Optional können verschiedenartige Fehlersignale bereitgestellt werden, welche das Differenzieren zwischen unterschiedlichen Arten von möglichen Fehlern erlauben. Das Fehlersignal kann optional in Form eines elektrischen Signals bereitgestellt werden. Optional kann das Fehlersignal als Spannungssignal bereitgestellt werden. Alternativ oder zusätzlich kann das Fehlersignal als computerlesbares Signal bereitgestellt werden.

Ein integrierter Schaltkreis (IC) ist ein Halbleiterbauelement, auf dem zahlreiche elektronische Komponenten wie Transistoren, Dioden, Widerstände und Kondensatoren auf einem einzigen, meist aus Silizium bestehenden Chip vereint sein können. Diese Bauteile können durch leitfähige Verbindungen miteinander verschaltet sein, sodass komplexe Schaltungen auf kleinstem Raum realisiert sein können.

Ein elektronischer Schalter ist ein Halbleiterbauelement, das zur schnellen und kontaktlosen Steuerung elektrischer Signale in Schaltungen eingesetzt werden kann. Ein elektronischer Schalter kann dazu ausgestaltet sein, indem er durch ein Steuersignal zwischen einem leitenden (ein) und einem sperrenden (aus) Zustand wechselt und so den Stromfluss im Lastkreis kontrolliert. Ein elektronischer Schalter kann dadurch das effiziente Ein- und Ausschalten von elektrischen Geräten oder Baugruppen ohne mechanische Verschleißteile ermöglichen. Ein elektronischer Schalter kann optional als Schalttransistor ausgebildet sein. Alternativ oder zusätzlich kann der elektronische Schalter einen Bipolartransistor, einen MOSFET, ein Halbleiterrelais und/oder einen piezoelektrischen Schalter umfassen. Der elektronische Schalter kann in einem geöffneten Zustand und in einem geschlossenen Zustand vorliegen. Der elektronische Schalter kann dazu ausgelegt sein, in geöffnetem Zustand im Wesentlichen keinen Strom zu leiten und in geschlossenem Zustand Strom zu leiten. "Im Wesentlichen keinen Strom zu leiten" bedeutet dabei, dass in geöffnetem Zustand der Stromfluss vollständig unterbunden ist, wobei bedingt durch die Grenzen des Designs und der Herstellbarkeit vernachlässigbare Ströme durch den elektronischen Schalter fließen können.

Zur Spannungsänderung der Ausgangsspannung relativ zur Eingangsspannung kann eine Diode eingesetzt werden. Alternativ oder zusätzlich zur Diode kann ein externen Schalter eingesetzt werden.

Mit einer offenbarungsgemäßen Messvorrichtung kann erkannt werden, ob sich die Schaltwandleranordnung in einem Fehlerzustand befindet. Optional kann mit einer offenbarungsgemäßen Messvorrichtung erkannt werden, ob ein Fehler in einem oder mehreren externen Elementen ein Fehlerzustand vorliegt. Ein Fehlerzustand kann optional dann vorliegen, wenn ein oder mehrere externe Elemente einen Defekt oder eine Fehlfunktion aufweisen oder nicht in einer vorgesehenen Weise mit dem integrierten Schaltkreis verbunden sind. Mit der offenbarungsgemäßen Messvorrichtung können Fehlfunktionen und/oder Schäden vermieden werden, da Fehlerzustände der Schaltwandleranordnung erkannt werden können und ggf. Maßnahmen vorgeschlagen oder eingeleitet werden können, die das Entstehen von daraus resultierenden Schäden abwenden können. Optional kann die Messvorrichtung durch das bereitgestellte Fehlersignal eine Inbetriebnahme einer Schaltwandleranordnung bei Vorliegen eines Fehlerfalls abwenden oder einer anderen Instanz einen Handlungsbedarf signalisieren.

Ferner kann mit einer offenbarungsgemäßen Messvorrichtung eine funktionale Sicherheit erhöht werden, da dadurch die Möglichkeit geschaffen werden kann, Fehlerzustände des Schaltwandlers zuverlässig zu erkennen.

Die Messvorrichtung kann dazu eingerichtet sein, das Vorliegen eines Fehlerzustands vor einer Inbetriebnahme der Schaltwandleranordnung und/oder während einer Inbetriebnahme der Schaltwandleranordnung, und/oder während eines Betriebs der Schaltwandleranordnung zu ermitteln. Dies bietet die Möglichkeit, Fehlerzustände zu erkennen, die lediglich vor und/oder während der Inbetriebnahme erkennbar sind oder nur während des Betriebs erkennbar sind oder während des Betriebs auftreten. Ferner kann dadurch das Vorliegen eines Fehlerzustands erkannt werden, bevor die Schaltwandleranordnung den Betrieb aufnimmt, sodass etwaige Schäden durch einen Betrieb im Fehlerzustand vermieden werden können. Zudem kann dadurch optional eine laufende Funktionsüberwachung während des Betriebs der Schaltwandleranordnung erfolgen.

Die Messvorrichtung kann dazu eingerichtet sein, zumindest zwei oder alle drei der Eingangsspannung, der Spannung an einem Schaltausgang der Schaltwandleranordnung, und der Ausgangsspannung der Schaltwandleranordnung zu messen. Dies kann die Möglichkeit bieten, eine Vielzahl unterschiedlicher Fehlerzustände zu erkennen. Manche Fehlerzustände können optional nur anhand mancher der Spannungssignale erkennbar sein. Die Messung mehrerer oder aller der genannten Spannungssignale kann die Möglichkeit bieten, das etwaige Vorliegen verschiedenartiger Fehlerzustände zu ermitteln.

Die Messvorrichtung kann zumindest einen Komparator aufweisen und dazu eingerichtet sein, das Vorliegen eines Fehlerzustands unter Verwendung des zumindest einen Messwerts der Eingangsspannung, der Spannung am Schaltausgang und/oder der Ausgangsspannung mittels einer Schwellwertmessung unter Verwendung des Komparators zu ermitteln. Optional kann die Messvorrichtung dazu eingerichtet sein, mittels des Komparators den Messwert mit einem vorgegebenen Schwellwert und/oder mit einem vorgegebenen Wertebereich zu vergleichen. Optional kann die Messvorrichtung dazu eingerichtet sein, das Vorliegen eines Fehlerzustands zu erkennen, wenn der Messwert in einem vorgegebenen Verhältnis zum Schwellwert liegt, wenn also der Messwert den Schwellwert übersteigt oder hinter dem Schwellwert zurückbleibt oder innerhalb oder außerhalb eines vorgegebenen Wertebereichs liegt. Optional sind die Abweichungen der Messwerte zwischen einem Gutfall, der einen Zustand ordnungsgemäßer Funktionstüchtigkeit der Schaltwandleranordnung indiziert, und einem Fehlerzustand sehr groß, sodass für die Unterscheidung eines Fehlerzustands vom Gutfall nicht zwingend eine hohe Genauigkeit erforderlich sein muss. Optional kann es ausreichend sein, wenn die Messung mit einer geringen Genauigkeit durchgeführt wird. Dies kann das Erreichen einer hohen Messgeschwindigkeit begünstigen und die wiederholte Durchführung der Messung in kurzen Zeitabständen ermöglichen. Optional kann, optional bei schnellen Messungen, eine Messgenauigkeit der Spannungsmessungen mit einer Fehlertoleranz von ±100 mV oder gar ±200 mV oder gar ±500 mV ausreichend sein, um einen Gutfall von einem Fehlerzustand zu unterscheiden.

Die Messvorrichtung kann zumindest einen Analog-Digital-Wandler aufweisen und dazu eingerichtet sein, das Vorliegen eines Fehlerzustands unter Verwendung des zumindest einen Messwerts der Eingangsspannung, der Spannung am Schaltausgang und/oder der Ausgangsspannung mittels einer Differenzbewertung zumindest zwei der Messwerte der Eingangsspannung, der Spannung am Schaltausgang und der Ausgangsspannung unter Verwendung des Analog-Digital-Wandlers zu ermitteln. Optional können mehrere Messwerte mit einer Differenzbewertung verglichen werden. Dadurch kann eine höhere Messgenauigkeit erzielt werden. Die Messvorrichtung kann dazu ausgelegt sein, im Rahmen der Differenzbewertung die ermittelte Differenz der Messwerte mit einem vorgegebenen Schwellwert oder einem vorgegebenen Wertebereich zu vergleichen. Die Messvorrichtung kann dazu ausgelegt sein, zu prüfen, ob die Differenz der Messwerte einen vorgegebenen Schwellwert übersteigt, hinter einem vorgegebenen Schwellwert zurück bleibt oder innerhalb oder außerhalb eines vorgegebenen Wertebereichs liegt. Dies kann optional in solchen Fällen Anwendung finden, in denen eine hohe Messgenauigkeit erforderlich ist, um einen Fehlerzustand von einem Gutfall zu unterscheiden.

Ferner wird ein integrierter Schaltkreis zur Verwendung in einer Schaltwandleranordnung bereitgestellt. Der integrierte Schaltkreis umfasst einen elektronischen Schalter und einen Regler zur Regelung der Ausgangsspannung unter Verwendung des elektronischen Schalters. Der integrierte Schaltkreis umfasst ferner eine offenbarungsgemäße Messvorrichtung.

Sämtliche für die Messvorrichtung bereitgestellte Offenbarung ist auch als für den integrierten Schaltkreis offenbart anzusehen und umgekehrt.

Die Messvorrichtung kann zusammen mit dem Regler und dem elektronischen Schalter einen Teil eines integrierten Schaltkreises bilden. Dadurch kann der Regler mit dem elektronischen Schalter und mit der Messvorrichtung einstückig als integrierter Schaltkreis bereitgestellt werden. Dies ermöglicht, die Funktionen der Messvorrichtung zu nutzen, ohne noch eine separate Messvorrichtung extern bereitstellen zu müssen. Dennoch ist es gemäß anderen Ausführungsformen möglich, die Messvorrichtung oder eine zusätzliche Messvorrichtung extern bereitzustellen und mit einem integrierten Schaltkreis, der den Regler und einen elektronischen Schalter enthält, zu kombinieren.

Der integrierte Schaltkreis kann zur Verwendung in einer mehrphasigen Schaltwandleranordnung ausgebildet sein und einen zweiten elektronischen Schalter umfassen. Der Regler kann ferner zur Regelung der Ausgangsspannung unter Verwendung des zweiten elektronischen Schalters eingerichtet sein. Mit anderen Worten ausgedrückt kann der Regler dazu ausgelegt sein, dass zur Regelung der Ausgangsspannung der erste und der zweite elektronische Schalter verwendet werden. Der bisweilen einfach als "elektronischer Schalter" bezeichnete elektronische Schalter kann auch als "erster elektronischer Schalter" bezeichnet werden, insbesondere wenn ein zweiter elektronischer Schalter vorhanden ist. Der zweite elektronische Schalter kann den Vorteil bieten, dass für jede Phase in zweiphasigen Systemen ein elektronischer Schalter zur Einwirkung auf die Spannung in der jeweiligen Phase verfügbar ist. Optional kann der integrierte Schaltkreis mehr als zwei elektronische Schalter aufweisen, um auch für Systeme mit mehr als zwei Phasen geeignet zu sein. Optional kann der integrierte Schaltkreis drei elektronische Schalter aufweisen, um für Systeme mit drei Phasen geeignet zu sein. Optional sind in diesem Fall alle drei elektronischen Schalter mit demselben Regler verbunden und werden von dem Regler zur Regelung der Ausgangsspannung verwendet.

Der integrierte Schaltkreis mit mindestens einem zweiten elektronischen Schalter kann dabei dazu eingerichtet sein, mittels der Messvorrichtung zu ermitteln, ob der integrierte Schaltkreis an ein Mehrphasensystem oder ein einphasiges System angeschlossen ist. Mit anderen Worten ausgedrückt, kann der integrierte Schaltkreis dazu eingerichtet sein, zu prüfen, ob die externen Elemente einem mehrphasigen System entsprechen, oder ob der mit mehreren elektronischen Schaltern ausgestattete integrierte Schaltkreis mit externen Elementen eines einphasigen Systems verbunden ist. Ebenso kann der integrierte Schaltkreis dazu eingerichtet sein, zu ermitteln, ob die Anzahl der Phasen der externen Elemente der Anzahl der im integrierten Schaltkreis bereitgestellten elektronischen Schalter entspricht, oder ob diesbezüglich eine Abweichung besteht. Optional ist der integrierte Schaltkreis dazu eingerichtet, etwaige Abweichungen der Anzahl der Phasen der externen Elemente von der Anzahl der elektronischen Schalter des integrierten Schaltkreises mittels der Messvorrichtung zu erkennen und ggf. eine Funktion des integrierten Schaltkreises anzupassen, zu unterbinden und/oder zu beenden, um eine Fehlfunktion und/oder das Auftreten von Beschädigungen zu vermeiden. Dies kann zudem den Vorteil bieten, dass aufgrund der automatischen Erkennung des Ein- oder Mehrphasensystems eine Konfiguration des integrierten Schaltkreises, optional über ein IC-Pin oder eine Registereinstellung, obsolet wird und somit der Aufwand für die Inbetriebnahme der Schaltwandleranordnung reduziert wird. Mit anderen Worten ausgedrückt kann eine automatische Erkennung der Ausgangsbeschaltung bzw. der externen Elemente erfolgen, welche dem Regler übergeben werden kann und eine Anpassung des Reglers zur Ansteuerung der elektronischen Schalter an die angeschlossene Außenbeschaltung bzw. die angeschlossenen externen Elemente erlaubt.

Ferner wird eine Schaltwandleranordnung bereitgestellt, die einen integrierten Schaltkreis mit einem elektronischen Schalter und einem Regler zur Regelung einer Ausgangsspannung mittels des elektronischen Schalters umfasst, wobei der elektronische Schalter mit einem Schaltausgang des integrierten Schaltkreises verbunden ist. Die Schaltwandleranordnung umfasst ferner mit dem integrierten Schaltkreis verbundene externe Elemente, wobei die externen Elemente zumindest ein Filterelement und eine Diode und/oder einen externen Schalter zur Spannungsänderung einer Ausgangsspannung relativ zu einer Eingangsspannung umfassen. Die Schaltwandleranordnung ist dazu eingerichtet, die Ausgangsspannung mittels des Reglers unter Verwendung des elektronischen Schalters und der Diode bzw. des externen Schalters zu regeln. Der integrierte Schaltkreis umfasst ferner eine Messvorrichtung, die dazu eingerichtet ist, eine Eingangsspannung und/oder eine Spannung am Schaltausgang und/oder die Ausgangsspannung zu messen. Die Messvorrichtung ist ferner dazu eingerichtet, um unter Verwendung des zumindest einen Messwerts der Eingangsspannung, der Spannung am Schaltausgang und/oder der Ausgangsspannung ein Vorliegen eines Fehlerzustands der Schaltwandleranordnung zu ermitteln, und ein Fehlersignal bereitzustellen, sofern das Vorliegen eines Fehlerzustands ermittelt wurde.

Sämtliche für die Messvorrichtung und/oder den integrierten Schaltkreis bereitgestellte Offenbarung ist auch als für die Schaltwandleranordnung offenbart anzusehen und umgekehrt.

Das Filterelement kann zumindest eine Spule und/oder einen Kondensator umfassen. Das Filterelement kann dazu ausgelegt sein, eine Frequenzfilterung der Ausgangsspannung vorzunehmen und/oder einen zeitlichen Spannungsverlauf der Ausgangsspannung zu glätten und/oder zu stabilisieren.

Der Schaltausgang kann mit einem Knoten zwischen der Eingangsspannung und der Diode bzw. dem externen Schalter verbunden sein. Dies kann dazu dienen, dass mittels des durch den Regler gesteuerten elektronischen Schalters, der mit dem Schaltausgang verbunden ist, eine Verbindung mit einem vorbestimmten Potenzial, etwa einem Massepotenzial, verbunden werden kann.

Der integrierte Schaltkreis der Schaltwandleranordnung kann ferner einen zweiten elektronischen Schalter umfassen. Die externen Elemente können zumindest ein zweites Filterelement und eine zweite Diode bzw. einen zweiten externen Schalter zur Spannungsänderung der Ausgangsspannung relativ zu einer Eingangsspannung umfassen. Der Regler kann dazu eingerichtet sein, die Ausgangsspannung ferner unter Verwendung des zweiten elektronischen Schalters und der zweiten Diode bzw. dem zweiten externen Schalter zu regeln. Dadurch kann die Schaltwandleranordnung für ein Mehrphasensystem geeignet sein. Optional kann die Messvorrichtung der Schaltwandleranordnung dazu eingerichtet sein, zu erkennen, ob die mit dem integrierten Schaltkreis verbundenen externen Elemente einem Mehrphasensystem entsprechen oder nicht und/oder ob die Anzahl der Phasen der Anzahl der elektronischen Schalter und/oder der Schaltausgänge des integrierten Schaltkreises entsprechen, oder nicht.

Ferner wird ein Verfahren zur Funktionsüberprüfung einer Schaltwandleranordnung bereitgestellt. Das Verfahren umfasst ein Messen einer Eingangsspannung und/oder einer Spannung an einem Schaltausgang und/oder einer Ausgangsspannung der Schaltwandleranordnung. Ferner umfasst das Verfahren ein Ermitteln eines Vorliegens eines Fehlerzustands der Schaltwandleranordnung unter Verwendung des zumindest einen Messwerts der Eingangsspannung und/oder der Spannung am Schaltausgang und/oder der Ausgangsspannung. Das Verfahren umfasst ferner ein Bereitstellen eines Fehlersignals, sofern das Vorliegen eines Fehlerzustands der Schaltwandleranordnung ermittelt wurde.

Sämtliche für die Messvorrichtung und/oder den integrierten Schaltkreis und/oder die Schaltwandleranordnung bereitgestellte Offenbarung ist auch als für das Verfahren als offenbart anzusehen und umgekehrt.

Der im Verfahren verwendete integrierte Schaltkreis kann dabei als ein offenbarungsgemäßer integrierter Schaltkreis ausgebildet sein. Die im Verfahren geprüfte Schaltwandleranordnung kann dabei eine offenbarungsgemäße Schaltwandleranordnung sein.

Durch das Verfahren kann das Vorliegen eines Fehlerzustands in der Schaltwandleranordnung ermittelt werden. Optional können dadurch die Entstehung von Fehlfunktionen und/oder Beschädigungen vermieden werden. Optional kann durch das Verfahren die funktionale Sicherheit der Schaltwandleranordnung und damit verbundener Komponenten und Systeme erhöht werden.

Das Verfahren kann ferner ein Anpassen und/oder Einstellen und/oder Unterbinden eines Betriebs der Schaltwandleranordnung in Abhängigkeit vom Fehlersignal, und/oder ein Ausgeben eines Hinweissignals in Abhängigkeit vom Fehlersignal, umfassen. Dadurch kann der Betrieb der Schaltwandleranordnung bei Vorliegen eines Fehlerzustands vermieden werden und/oder daraus möglicherweise entstehende Schäden reduziert oder vermieden werden.

Das Ermitteln des Vorliegens eines Fehlerzustands kann ein oder mehrere der folgenden Vorgänge umfassen:
Feststellen eines ersten Fehlerzustands, wenn bei geöffnetem elektronischem Schalter, gemessener Eingangsspannung und gemessener Spannung am Schaltausgang eine Abweichung zwischen der Eingangsspannung und der Spannung am Schaltausgang ermittelt wird, die einen vorbestimmten ersten Schwellwert übersteigt. Optional kann dies vor dem Start des Reglers und/oder vor dem Start des integrierten Schaltkreises und/oder vor dem Start der Schaltwandleranordnung durchgeführt werden. Optional können dadurch das Vorliegen einer mangelnden oder mangelhaften Kontaktierung einer Spule des Filterelements und/oder das Vorliegen einer mangelnden oder mangelhaften Kontaktierung des elektronischen Schalters und/oder ein Kurzschluss des elektronischen Schalters nach Masse als Ursache des ersten Fehlerzustands ermittelt werden.

Feststellen eines zweiten Fehlerzustands, wenn bei geöffnetem elektronischem Schalter, gemessener Spannung am Schaltausgang und gemessener Ausgangsspannung eine Abweichung zwischen der Spannung am Schaltausgang und der Ausgangsspannung ermittelt wird, die einen vorbestimmten zweiten Schwellwert übersteigt. Alternativ oder zusätzlich kann der zweite Fehlerzustand festgestellt werden, wenn bei geöffnetem elektronischem Schalter und gemessener Ausgangsspannung die gemessene Ausgangspannung einen vorbestimmten dritten Schwellwert übersteigt. Optional kann dies vor dem Start des Reglers und/oder vor dem Start des integrierten Schaltkreises und/oder vor dem Start der Schaltwandleranordnung durchgeführt werden. Optional können dadurch das Vorliegen einer mangelnden oder mangelhaften Kontaktierung der Diode bzw. des externen Schalters und/oder das Vorliegen einer mangelnden oder mangelhaften Kontaktierung eines Eingangs des Reglers als Ursache des zweiten Fehlerzustands ermittelt werden.

Feststellen eines dritten Fehlerzustands, wenn bei geschlossenem elektronischem Schalter und gemessener Spannung am Schaltausgang die gemessene Spannung am Schaltausgang einen vorbestimmten vierten Schwellwert übersteigt. Optional kann dies während des Betriebs der Schaltwandleranordnung und/oder bei Einspeisen eines ersten Testpulses durchgeführt werden. Optional kann dadurch das Vorliegen eines Kurzschlusses in der Spule des Filterelements als Ursache des dritten Fehlerzustands ermittelt werden.

Feststellen eines vierten Fehlerzustands, wenn bei geschlossenem elektronischem Schalter und gemessener Ausgangsspannung eine variierende und/oder absinkende Ausgangsspannung ermittelt wird. Optional kann dies während des Betriebs der Schaltwandleranordnung und/oder bei Einspeisen eines ersten Testpulses durchgeführt werden. Optional kann dadurch das Vorliegen eines Kurzschlusses in der Diode bzw. im externen Schalter als Ursache des vierten Fehlerzustands ermittelt werden.

Feststellen eines fünften Fehlerzustands, wenn bei geöffnetem elektronischem Schalter, gemessener Ausgangsspannung und gemessener Spannung am Schaltausgang eine Spannung am Schaltausgang ermittelt wird, die die Ausgangsspannung nicht übersteigt. Optional kann dies während des Betriebs der Schaltwandleranordnung und/oder nach Einspeisen eines ersten Testpulses durchgeführt werden. Optional kann dadurch das Vorliegen eines Kurzschlusses in der Diode bzw. im externen Schalter als Ursache des fünften Fehlerzustands ermittelt werden.

Feststellen eines sechsten Fehlerzustands, wenn bei Inbetriebnahme der Schaltwandleranordnung und gemessener Ausgangsspannung ein Anstieg der Ausgangsspannung einen vorbestimmten fünften Schwellwert übersteigt. Optional kann dadurch das Vorliegen einer mangelnden oder mangelhaften Kontaktierung der Kapazität bzw. des Kondensators des Filterelements als Ursache des sechsten Fehlerzustands ermittelt werden.

Das Ermitteln des Vorliegens eines Fehlerzustands einer Schaltwandleranordnung mit zwei elektronischen Schaltern kann ferner ein Feststellen eines siebten Fehlerzustands umfassen, wenn bei geöffnetem ersten elektronischen Schalter und geschlossenem zweiten elektronischen Schalter und gemessener Spannung am Schaltausgang des ersten elektronischen Schalters und gemessener Spannung am Schaltausgang des zweiten elektronischen Schalters eine Spannung am Schaltausgang des ersten elektronischen Schalters ermittelt wird, die einen vorbestimmten sechsten Schwellwert nicht übersteigt und eine Spannung am Schaltausgang des zweiten elektronischen Schalters ermittelt wird, die den sechsten Schwellwert übersteigt. Optional kann dadurch automatisch erkannt werden, wenn keine Mehrphasenaußenbeschaltung des für ein Mehrphasensystem ausgelegten integrierten Schaltkreises vorliegt.

Ferner kann der siebte Fehlerzustand festgestellt werden, wenn bei geöffnetem ersten elektronischen Schalter und geschlossenem zweiten elektronischen Schalter und gemessener Spannung am Schaltausgang des ersten elektronischen Schalters und gemessener Eingangsspannung ermittelt wird, dass die Spannung am Schaltausgang des ersten elektronischen Schalters nicht ähnlich zur Eingangsspannung ist bzw. eine Abweichung größer als ±0,5 V ist.

Die Messvorrichtung kann optional weitere Funktionen ausüben. Optional kann eine bereits für andere Zwecke vorhandene Einheit derart eingerichtet werden, um als Messvorrichtung im Sinne der Offenbarung zu dienen und/oder um ein offenbarungsgemäßes Verfahren auszuführen.

Der Regler des integrierten Schaltkreises kann am Reglereingang und/oder am Schaltausgang einen Spannungsteiler aufweisen, welcher dazu ausgelegt sein kann, eine Spannung am Reglereingang auf 0V zu bringen, wenn das Signal nicht extern übertrieben wird.

Vor einem Start des Reglers bzw. der Schaltwandleranordnung kann die Spannung am Schaltausgang im Gutfall, d.h. bei ordnungsgemäßer Funktion, gleich der Eingangsspannung sein oder nur in vernachlässigbarer Weise von dieser abweichen, etwa um nicht mehr als ±0,1 V. Sollte jedoch als Fehler eine unkontaktierte Spule oder Schalter vorliegen, ist die Spannung nahe null und kann somit als Fehler erkannt werden. Gleiches gilt für einen nach Masse kurzgeschlossenen Schalter. Optional genügt hier eine grobe Schwellwertmessung der Spannung am Schaltausgang mittels eines Komparators. Ein weiterer Informationsgewinn kann mittels einer Messung mit einem Analog-Digital-Wandler und/oder mittels Differenzbewertung der Eingangsspannung und der Spannung am Schaltausgang erfolgen. Im gleichen Zustand kann im Gutfall die Ausgangsspannung in etwa um eine Diodenflussspannung kleiner als die Eingangsspannung ausgestaltet sein. Im Fehlerfall einer unkontaktierten Diode bzw. eines unkontaktierten externen Schalters und/oder eines unkontaktierten Reglereingangs kann die gemessene Spannung zu null werden. Damit können optional diese Fehler erkannt werden. Falls eine Messung mit mehr Präzision z.B. mittels Analog-Digital-Wandlers oder eine Differenzmessung genutzt wird, kann in diesem Zustand optional auch ein Kurzschluss der Diode bzw. des externen Schalters erkannt werden, indem die Spannungsdifferenz zwischen der Spannung am Schaltausgang und der Ausgangsspannung einen Schwellwert unterschreitet. Wird der Schalter nun für einen Testpuls oder im laufenden Betrieb geschlossen, kann eine Prüfung der Spannung am Schaltausgang erfolgen, welche einen gewissen Schwellwert unterschreiten sollte. Ist dies nicht der Fall, könnte ein Kurzschluss in der Spule die Ursache dafür sein. Falls hierbei auch die Ausgangsspannung absinkt, zeigt dies einen Kurzschluss der Diode bzw. des externen Schalters an.

Ein Kurzschluss der Diode bzw. des externen Schalters kann im laufenden Betrieb ebenfalls detektiert werden, falls die Spannung am Schaltausgang nie die Ausgangsspannung übersteigt.

Während eines Anlaufens des Reglers kann anhand des Spannungsanstieges der Ausgangsspannung eine fehlende oder zu geringe Kapazität detektiert werden. Die Begriffe "Kapazität" und "Kondensator" sollen im Rahmen der vorliegenden Offenbarung als Synonyme verwendet werden.

Bei Mehrphasenwandlern, d.h. Schaltwandleranordnungen für Mehrphasensysteme, welche die Option auf einphasigen Betrieb haben, kann über die Messung an den Schaltausgängen die gewählte Konfiguration automatisch erkannt werden. Folgt bei einem Testpuls an einem Schaltausgang der zweite Schaltausgang, so kann eine Einphasenkonfiguration vorliegen.

Andernfalls kann eine Beschaltung für den mehrphasigen Betrieb vorliegen. Eine Konfiguration über einen IC-Pin oder eine Registereinstellung ist dann nicht mehr vonnöten.

Die oben genannten und im Folgenden erläuterten Merkmale und Ausführungsformen sind dabei nicht nur als in den jeweils explizit genannten Kombinationen offenbart anzusehen, sondern sind auch in anderen technisch sinnhaften Kombinationen und Ausführungsformen vom Offenbarungsgehalt umfasst.

Weitere Einzelheiten und Vorteile sollen nun anhand von den folgenden Beispielen und optionalen Ausführungsformen mit Bezug auf die Figuren näher erläutert werden.

Es zeigen:
- Fig. 1: eine Messvorrichtung gemäß einer optionalen Ausführungsform;
- Fig. 2: einen integrierten Schaltkreis gemäß einer optionalen Ausführungsform;
- Fig. 3A: eine Schaltwandleranordnung gemäß einer optionalen Ausführungsform;
- Fig. 3B: eine Schaltwandleranordnung gemäß einer weiteren optionalen Ausführungsform;
- Fig. 3C: die Schaltwandleranordnung gemäß Figur 3B in unpassender Konfiguration; und
- Fig. 4: illustriert ein Verfahren zur Funktionsüberprüfung einer Schaltwandleranordnung gemäß einer optionalen Ausführungsform.

In den folgenden Figuren werden gleiche oder ähnliche Elemente in den verschiedenen Ausführungsformen der Einfachheit halber mit gleichen Bezugszeichen bezeichnet.

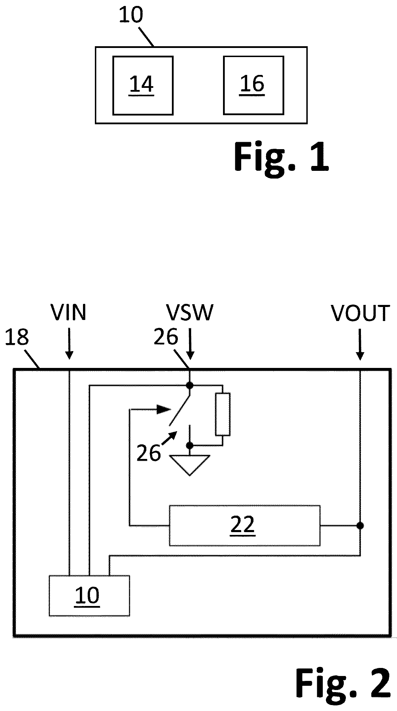

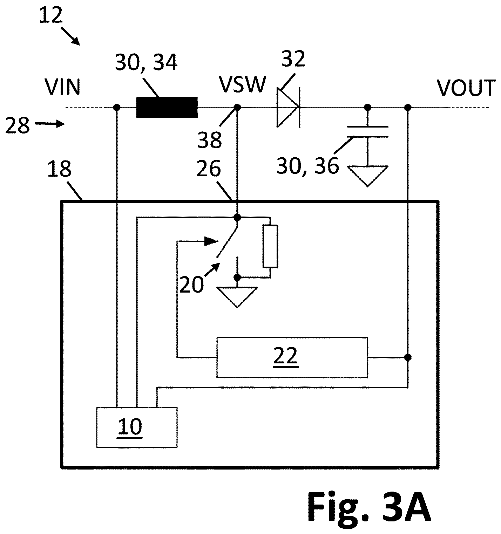

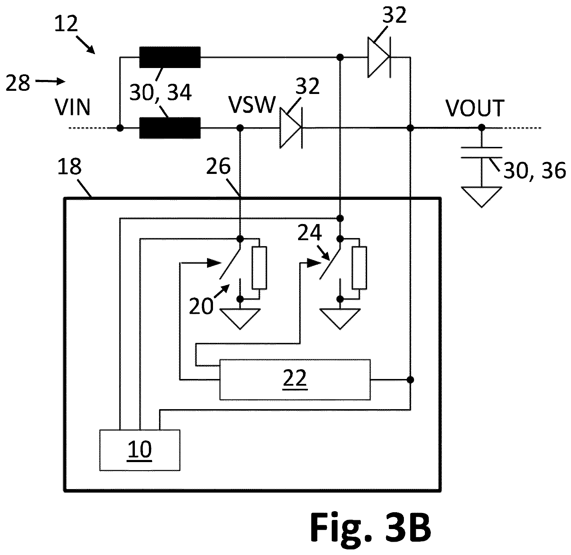

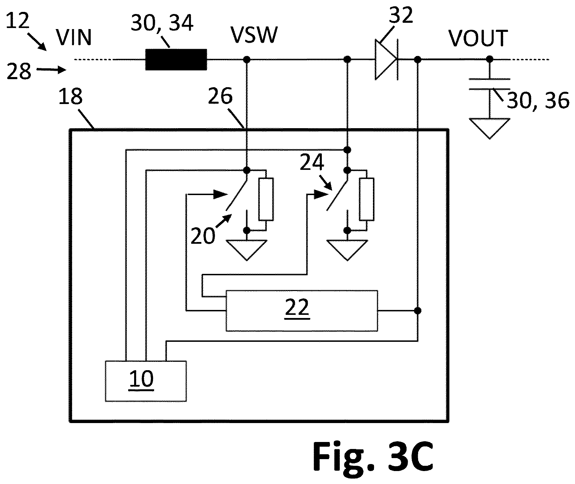

Figur 1 zeigt in einer schematischen Darstellung eine Messvorrichtung 10 zur Funktionsüberprüfung einer Schaltwandleranordnung 12 (siehe Figur 3) gemäß einer optionalen Ausführungsform. Die Messvorrichtung 10 kann als separates Bauteil bereitgestellt werden, oder in einem integrierten Schaltkreis 18 integriert sein, wie mit Bezug auf Figur 2 im Folgenden beschrieben, wobei der integrierte Schaltkreis 18 wiederum Teil einer Schaltwandleranordnung 12 sein kann.

Hinsichtlich der im Folgenden erläuterten Funktion der Messvorrichtung 10 kann somit auf Elemente Bezug genommen werden, die lediglich in Figur 2, Figur 3A und/oder Figur 3B gezeigt sind.

Figur 2 zeigt einen integrierten Schaltkreis 18 gemäß einer optionalen Ausführungsform. Der integrierte Schaltkreis 18 dient zur Verwendung in einer Schaltwandleranordnung 12 (siehe Figur 3) und umfasst einen elektronischen Schalter 20 und einen Regler 22 zur Regelung der Ausgangsspannung VOUT unter Verwendung des elektronischen Schalters 20.

Der integrierte Schaltkreis 18 umfasst ferner eine Messvorrichtung 10. Die Messvorrichtung 10 ist dazu eingerichtet, eine Eingangsspannung VIN und/oder eine Spannung VSW an einem Schaltausgang 26 der Schaltwandleranordnung 12 bzw. des integrierten Schaltkreises 18 und/oder einer Ausgangsspannung VOUT der Schaltwandleranordnung 12 zu messen, unter Verwendung des zumindest einen Messwerts der Eingangsspannung VIN, der Spannung VSW am Schaltausgang 26 und/oder der Ausgangsspannung VOUT ein Vorliegen eines Fehlerzustands F der Schaltwandleranordnung 12 zu ermitteln, und ein Fehlersignal bereitzustellen, sofern das Vorliegen eines Fehlerzustands F der Schaltwandleranordnung 12 ermittelt wurde.

Die Messvorrichtung 10 kann dazu eingerichtet sein, das Vorliegen eines Fehlerzustands F vor einer Inbetriebnahme der Schaltwandleranordnung 12 und/oder während einer Inbetriebnahme der Schaltwandleranordnung 12 und/oder während eines Betriebs der Schaltwandleranordnung 12 durchzuführen.

Die Messvorrichtung 10 kann ferner dazu eingerichtet sein, zumindest zwei oder alle drei der Eingangsspannung VIN, der Spannung VSW an einem Schaltausgang 26 der Schaltwandleranordnung 12 und der Ausgangsspannung VOUT der Schaltwandleranordnung 12 zu messen.

Die Messvorrichtung 10 weist optional zumindest einen Komparator 14 auf und kann dazu eingerichtet sein, das Vorliegen eines Fehlerzustands F unter Verwendung des zumindest einen Messwerts der Eingangsspannung VIN, der Spannung VSW am Schaltausgang 26 und/oder der Ausgangsspannung VOUT mittels einer Schwellwertmessung unter Verwendung des Komparators 14 zu ermitteln.

Die Messvorrichtung 10 kann zumindest einen Analog-Digital-Wandler 16 aufweisen und dazu eingerichtet sein, das Vorliegen eines Fehlerzustands F unter Verwendung des zumindest einen Messwerts der Eingangsspannung VIN, der Spannung VSW am Schaltausgang 26 und/oder der Ausgangsspannung VOUT mittels einer Differenzbewertung zumindest zwei der Messwerte der Eingangsspannung VIN, der Spannung VSW am Schaltausgang 26 und der Ausgangsspannung VOUT unter Verwendung des Analog-Digital-Wandlers 16 zu ermitteln.

Figur 3A zeigt eine Schaltwandleranordnung 12 gemäß einer optionalen Ausführungsform umfassend einen integrierten Schaltkreis 18 gemäß Figur 2 mit einem elektronischen Schalter 20 und einem Regler 22 zur Regelung einer Ausgangsspannung VOUT mittels des elektronischen Schalters 20, wobei der elektronische Schalter 20 mit einem Schaltausgang 26 des integrierten Schaltkreises 18 verbunden ist. Die Schaltwandleranordnung umfasst ferner mit dem integrierten Schaltkreis 18 verbundene externe Elemente 28, die zumindest ein Filterelement 30 und eine Diode 32 zur Spannungsänderung einer Ausgangsspannung VOUT relativ zu einer Eingangsspannung VIN umfassen, wobei die Schaltwandleranordnung 12 dazu eingerichtet ist, die Ausgangsspannung VOUT mittels des Reglers 22 unter Verwendung des elektronischen Schalters 20 und der Diode 32 zu regeln.

Der integrierte Schaltkreis 18 umfasst ferner eine Messvorrichtung 10, die dazu eingerichtet ist, eine Eingangsspannung VIN und/oder eine Spannung VSW am Schaltausgang 26 und/oder die Ausgangsspannung VOUT zu messen, unter Verwendung des zumindest einen Messwerts der Eingangsspannung VIN, der Spannung VSW am Schaltausgang 26 und/oder der Ausgangsspannung VOUT ein Vorliegen eines Fehlerzustands F der Schaltwandleranordnung 12 zu ermitteln und ein Fehlersignal bereitzustellen, sofern das Vorliegen eines Fehlerzustands F ermittelt wurde.

Das Filterelement 30 umfasst zumindest eine Spule 34 und/oder einen Kondensator 36. Der Schaltausgang 26 ist mit einem Knoten 38 zwischen der Eingangsspannung VIN und der Diode 32 verbunden.

Figur 3B zeigt eine Schaltwandleranordnung 12 gemäß einer weiteren Ausführungsform, welche abweichend von der in Figur 3A gezeigten Ausführungsform als ein Mehrphasensystem ausgebildet ist.

Dabei umfasst der integrierte Schaltkreis 18 ferner einen zweiten elektronischen Schalter 24 und die externen Elemente 28 umfassen zumindest ein zweites Filterelement 30 und eine zweite Diode 32 zur Spannungsänderung der Ausgangsspannung VOUT relativ zu einer Eingangsspannung VIN. Der Regler 22 ist dazu eingerichtet, die Ausgangsspannung VOUT ferner unter Verwendung des zweiten elektronischen Schalters 24 und der zweiten Diode 32 zu regeln.

Gemäß dieser Ausführungsform ist die Messvorrichtung 10 nicht dazu eingerichtet, die Eingangsspannung VIN zu messen, wenngleich dies gemäß abgewandelter Ausführungsformen der Fall sein kann.

Figur 3C zeigt eine Schaltwandleranordnung 12, bei der ein für ein Mehrphasensystem ausgelegter integrierter Schaltkreis 18, wie in Figur 3B gezeigt, an externe Elemente 28 eines Einphasensystems angeschlossen ist. Eine derartige Kombination kann zu Fehlfunktionen führen und es kann daher vorteilhaft sein, eine derartige Kombination zu vermeiden. Die Messvorrichtung 10 kann dazu ausgelegt sein, automatisch zu erkennen, ob der integrierte Schaltkreis 18 mit externen Elementen 28 eines Einphasensystems oder eines Mehrphasensystems verbunden ist und, sofern eine nicht kompatible Kombination erkannt wird, einen Fehlerzustand erkennen und ein entsprechendes Fehlersignal ausgeben. Alternativ oder zusätzlich zur Fehlererkennung kann auch eine automatische Erkennung der Ausgangsbeschaltung bzw. der externen Elemente 28 erfolgen, welche dem Regler 22 übergeben wird und welche eine Anpassung der Ansteuerung der elektronischen Schalter 20 und 24 durch den Regler an die vorliegende Ausgangsbeschaltung bzw. die verbundenen externen Elemente 28 erlaubt.

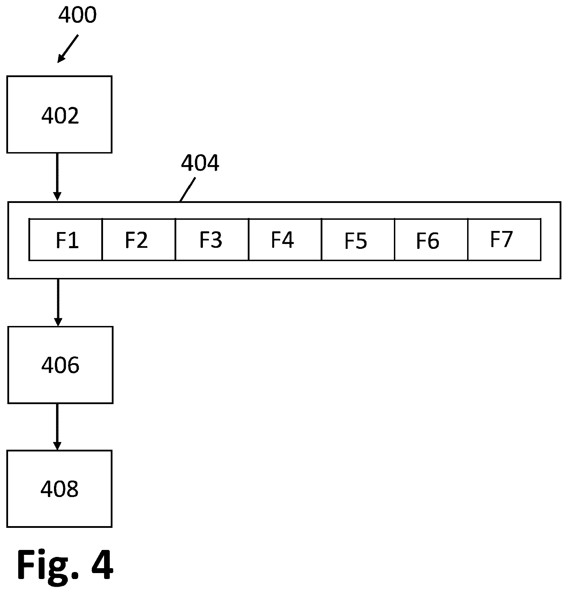

Figur 4 illustriert schematisch ein Verfahren 400 gemäß einer optionalen Ausführungsform zur Funktionsüberprüfung einer Schaltwandleranordnung 12 gemäß einer optionalen Ausführungsform.

Das Verfahren 400 umfasst ein Messen 402 einer Eingangsspannung VIN und/oder einer Spannung VSW an einem Schaltausgang 26 und/oder einer Ausgangsspannung VOUT der Schaltwandleranordnung 12.

Das Verfahren 400 umfasst ferner ein Ermitteln 404 eines Vorliegens eines Fehlerzustands F der Schaltwandleranordnung 12 unter Verwendung des zumindest einen Messwerts der Eingangsspannung VIN und/oder der Spannung VSW am Schaltausgang 26 und/oder der Ausgangsspannung VOUT.

Das Verfahren 400 umfasst ferner ein Bereitstellen 406 eines Fehlersignals, sofern das Vorliegen eines Fehlerzustands F der Schaltwandleranordnung 12 ermittelt wurde. Das Verfahren 400 umfasst ferner ein Anpassen und/oder Einstellen und/oder Unterbinden 408 eines Betriebs der Schaltwandleranordnung 12 in Abhängigkeit vom Fehlersignal, und/oder Ausgeben eines Hinweissignals in Abhängigkeit vom Fehlersignal.

Das Ermitteln 404 des Vorliegens eines Fehlerzustands F umfasst ein oder mehrere der folgenden Vorgänge:
Feststellen eines ersten Fehlerzustands F1, wenn bei geöffnetem elektronischem Schalter 20, gemessener Eingangsspannung VIN und gemessener Spannung VSW am Schaltausgang eine Abweichung zwischen der Eingangsspannung VIN und der Spannung VSW am Schaltausgang ermittelt wird, die einen vorbestimmten ersten Schwellwert übersteigt.

Feststellen eines zweiten Fehlerzustands F2, wenn bei geöffnetem elektronischem Schalter 20, gemessener Spannung VSW am Schaltausgang 26 und gemessener Ausgangsspannung VOUT eine Abweichung zwischen der Spannung VSW am Schaltausgang 26 und der Ausgangsspannung VOUT ermittelt wird, die einen vorbestimmten zweiten Schwellwert übersteigt. Alternativ oder zusätzlich Feststellen des zweiten Fehlerzustands F2, wenn bei geöffnetem elektronischem Schalter 20 und gemessener Ausgangsspannung VOUT die gemessene Ausgangspannung VOUT einen vorbestimmten dritten Schwellwert übersteigt.

Feststellen eines dritten Fehlerzustands F3, wenn bei geschlossenem elektronischem Schalter 20 und gemessener Spannung VSW am Schaltausgang 26 die gemessene Spannung VSW am Schaltausgang einen vorbestimmten vierten Schwellwert übersteigt.

Feststellen eines vierten Fehlerzustands F4, wenn bei geschlossenem elektronischem Schalter 20 und gemessener Ausgangsspannung VOUT eine variierende Ausgangsspannung ermittelt wird.

Feststellen eines fünften Fehlerzustands F5, wenn bei geöffnetem elektronischem Schalter 20, gemessener Ausgangsspannung VOUT und gemessener Spannung VSW am Schaltausgang 26 eine Spannung VSW am Schaltausgang ermittelt wird, die die Ausgangsspannung VOUT übersteigt.

Feststellen eines sechsten Fehlerzustands F6, wenn bei Inbetriebnahme der Schaltwandleranordnung 12 und gemessener Ausgangsspannung VOUT ein Anstieg der Ausgangsspannung VOUT einen vorbestimmten fünften Schwellwert übersteigt.

Das Ermitteln 404 des Vorliegens eines Fehlerzustands F einer Schaltwandleranordnung 12 mit zwei elektronischen Schaltern 20, 24 umfasst ferner den folgenden Vorgang:

Feststellen eines siebten Fehlerzustands F7, wenn bei geöffnetem ersten elektronischen Schalter 20 und geschlossenem zweiten elektronischen Schalter 24 und gemessener Spannung VSW am Schaltausgang 26 des ersten elektronischen Schalters 20 und gemessener Spannung VSW am Schaltausgang 26 des zweiten elektronischen Schalters 24 eine Spannung VSW am Schaltausgang des ersten elektronischen Schalters 20 ermittelt wird, die einen vorbestimmten sechsten Schwellwert nicht übersteigt und eine Spannung VSW am Schaltausgang 26 des zweiten elektronischen Schalters 24 ermittelt wird, die den sechsten Schwellwert übersteigt.

### Bezugszeichenliste

- 10: Messvorrichtung
- 12: Schaltwandleranordnung
- VIN: Eingangsspannung
- VSW: Spannung am Schaltausgang
- VOUT: Ausgangsspannung
- 14: Komparator
- 16: Analog-Digital-Wandler
- 18: Integrierter Schaltkreis
- 20: elektronischer Schalter
- 22: Regler
- 24: zweiter elektronischer Schalter
- 26: Schaltausgang
- 28: externe Elemente
- 30: Filterelement
- 32: Diode
- 34: Spule
- 36: Kondensator
- 38: Knoten
- 400: Verfahren zur Funktionsüberprüfung
- 402: Messen einer Spannung
- 404: Ermitteln eines Vorliegens eines Fehlerzustands F
- 406: Bereitstellen eines Fehlersignals
- 408: Einstellen/Unterbinden des Betriebs der Schaltwandleranordnung
- F1: erster Fehlerzustand
- F2: zweiter Fehlerzustand
- F3: dritter Fehlerzustand
- F4: vierter Fehlerzustand
- F5: fünfter Fehlerzustand
- F6: sechster Fehlerzustand
- F7: siebter Fehlerzustand

## Patentansprüche

1. Messvorrichtung zur Funktionsüberprüfung einer Schaltwandleranordnung, **dadurch gekennzeichnet, dass** die Messvorrichtung dazu eingerichtet ist:
- eine Eingangsspannung und/oder eine Spannung an einem Schaltausgang der Schaltwandleranordnung und/oder einer Ausgangsspannung der Schaltwandleranordnung zu messen;
- unter Verwendung des zumindest einen Messwerts der Eingangsspannung, der Spannung am Schaltausgang und/oder der Ausgangsspannung ein Vorliegen eines Fehlerzustands der Schaltwandleranordnung zu ermitteln; und
- ein Fehlersignal bereitzustellen, sofern das Vorliegen eines Fehlerzustands der Schaltwandleranordnung ermittelt wurde.

2. Messvorrichtung gemäß Anspruch 1, wobei die Messvorrichtung dazu eingerichtet ist, das Vorliegen eines Fehlerzustands vor einer Inbetriebnahme der Schaltwandleranordnung und/oder während einer Inbetriebnahme der Schaltwandleranordnung und/oder während eines Betriebs der Schaltwandleranordnung durchzuführen.

3. Messvorrichtung gemäß Anspruch 1 oder 2, wobei die Messvorrichtung dazu eingerichtet ist, zumindest zwei oder alle drei der Eingangsspannung, der Spannung an einem Schaltausgang der Schaltwandleranordnung, und der Ausgangsspannung der Schaltwandleranordnung zu messen.

4. Messvorrichtung gemäß einem der vorhergehenden Ansprüche, wobei die Messvorrichtung zumindest einen Komparator aufweist und dazu eingerichtet ist, das Vorliegen eines Fehlerzustands unter Verwendung des zumindest einen Messwerts der Eingangsspannung, der Spannung am Schaltausgang und/oder der Ausgangsspannung mittels einer Schwellwertmessung unter Verwendung des Komparators zu ermitteln.

5. Messvorrichtung gemäß einem der vorhergehenden Ansprüche, wobei die Messvorrichtung zumindest einen Analog-Digital-Wandler aufweist und dazu eingerichtet ist, das Vorliegen eines Fehlerzustands unter Verwendung des zumindest einen Messwerts der Eingangsspannung, der Spannung am Schaltausgang und/oder der Ausgangsspannung mittels einer Differenzbewertung zumindest zwei der Messwerte der Eingangsspannung, der Spannung am Schaltausgang und der Ausgangsspannung unter Verwendung des Analog-Digital-Wandlers zu ermitteln.

6. Integrierter Schaltkreis zur Verwendung in einer Schaltwandleranordnung, der integrierte Schaltkreis umfassend:
- einen elektronischen Schalter; und
- einen Regler zur Regelung der Ausgangsspannung unter Verwendung des elektronischen Schalters;
**dadurch gekennzeichnet, dass**
der integrierte Schaltkreis ferner eine Messvorrichtung gemäß einem der Ansprüche 1 bis 5 umfasst.

7. Integrierter Schaltkreis gemäß Anspruch 6, wobei der integrierte Schaltkreis zur Verwendung in einer mehrphasigen Schaltwandleranordnung ausgebildet ist und ferner umfasst:
- einen zweiten elektronischen Schalter
wobei der Regler zur Regelung der Ausgangsspannung ferner unter Verwendung des zweiten elektronischen Schalters eingerichtet ist.

8. Schaltwandleranordnung, umfassend:
- einen integrierten Schaltkreis mit einem elektronischen Schalter und einem Regler zur Regelung einer Ausgangsspannung mittels des elektronischen Schalters, wobei der elektronische Schalter mit einem Schaltausgang des integrierten Schaltkreises verbunden ist;
- mit dem integrierten Schaltkreis verbundene externe Elemente, wobei die externen Elemente zumindest ein Filterelement und eine Diode und/oder einen externen Schalter zur Spannungsänderung einer Ausgangsspannung relativ zu einer Eingangsspannung umfassen;
wobei die Schaltwandleranordnung dazu eingerichtet ist, die Ausgangsspannung mittels des Reglers unter Verwendung des elektronischen Schalters und der Diode und/oder des externen Schalters zu regeln;
**dadurch gekennzeichnet, dass**
der integrierte Schaltkreis ferner eine Messvorrichtung umfasst, die dazu eingerichtet ist:
- eine Eingangsspannung und/oder eine Spannung am Schaltausgang und/oder die Ausgangsspannung zu messen;
- unter Verwendung des zumindest einen Messwerts der Eingangsspannung, der Spannung am Schaltausgang und/oder der Ausgangsspannung ein Vorliegen eines Fehlerzustands der Schaltwandleranordnung zu ermitteln; und
- ein Fehlersignal bereitzustellen, sofern das Vorliegen eines Fehlerzustands ermittelt wurde.

9. Schaltwandleranordnung gemäß Anspruch 8, wobei das Filterelement zumindest eine Spule und/oder einen Kondensator umfasst.

10. Schaltwandleranordnung gemäß Anspruch 8 oder 9, wobei der Schaltausgang mit einem Knoten zwischen der Eingangsspannung und der Diode und/oder dem externen Schalter verbunden ist.

11. Schaltwandleranordnung gemäß einem der Ansprüche 8 bis 10, wobei
- der integrierte Schaltkreis ferner einen zweiten elektronischen Schalter umfasst;
- die externen Elemente zumindest ein zweites Filterelement und eine zweite Diode und/oder einen zweiten externen Schalter zur Spannungsänderung der Ausgangsspannung relativ zu einer Eingangsspannung umfassen; und der Regler dazu eingerichtet ist, die Ausgangsspannung ferner unter Verwendung des zweiten elektronischen Schalters und der zweiten Diode und/oder des zweiten externen Schalters zu regeln.

12. Verfahren zur Funktionsüberprüfung einer Schaltwandleranordnung, **dadurch gekennzeichnet, dass** das Verfahren umfasst:
- Messen einer Eingangsspannung und/oder einer Spannung an einem Schaltausgang und/oder einer Ausgangsspannung der Schaltwandleranordnung;
- Ermitteln eines Vorliegens eines Fehlerzustands der Schaltwandleranordnung unter Verwendung des zumindest einen Messwerts der Eingangsspannung und/oder der Spannung am Schaltausgang und/oder der Ausgangsspannung; und
- Bereitstellen eines Fehlersignals, sofern das Vorliegen eines Fehlerzustands der Schaltwandleranordnung ermittelt wurde.

13. Verfahren gemäß Anspruch 12, ferner umfassend:
- Anpassen und/oder Einstellen und/oder Unterbinden eines Betriebs der Schaltwandleranordnung in Abhängigkeit vom Fehlersignal; und/oder
- Ausgeben eines Hinweissignals in Abhängigkeit vom Fehlersignal.

14. Verfahren gemäß Anspruch 12 oder 13, wobei das Ermitteln des Vorliegens eines Fehlerzustands ein oder mehrere der folgenden Vorgänge umfasst:
- Feststellen eines ersten Fehlerzustands, wenn bei geöffnetem elektronischem Schalter, gemessener Eingangsspannung und gemessener Spannung am Schaltausgang eine Abweichung zwischen der Eingangsspannung und der Spannung am Schaltausgang ermittelt wird, die einen vorbestimmten ersten Schwellwert übersteigt;
- Feststellen eines zweiten Fehlerzustands, wenn bei geöffnetem elektronischem Schalter, gemessener Spannung am Schaltausgang und gemessener Ausgangsspannung eine Abweichung zwischen der Spannung am Schaltausgang und der Ausgangsspannung ermittelt wird, die einen vorbestimmten zweiten Schwellwert übersteigt;
- Feststellen des zweiten Fehlerzustands, wenn bei geöffnetem elektronischem Schalter und gemessener Ausgangsspannung die gemessene Ausgangsspannung einen vorbestimmten dritten Schwellwert übersteigt;
- Feststellen eines dritten Fehlerzustands, wenn bei geschlossenem elektronischem Schalter und gemessener Spannung am Schaltausgang die gemessene Spannung am Schaltausgang einen vorbestimmten vierten Schwellwert übersteigt;
- Feststellen eines vierten Fehlerzustands, wenn bei geschlossenem elektronischem Schalter und gemessener Ausgangsspannung eine variierende Ausgangsspannung ermittelt wird;
- Feststellen eines fünften Fehlerzustands, wenn bei geöffnetem elektronischem Schalter, gemessener Ausgangsspannung und gemessener Spannung am Schaltausgang eine Spannung am Schaltausgang ermittelt wird, die die Ausgangsspannung nicht übersteigt; und
- Feststellen eines sechsten Fehlerzustands, wenn bei Inbetriebnahme der Schaltwandleranordnung und gemessener Ausgangsspannung ein Anstieg der Ausgangsspannung einen vorbestimmten fünften Schwellwert übersteigt.

15. Verfahren gemäß einem der Ansprüche 12 bis 14, wobei das Ermitteln des Vorliegens eines Fehlerzustands einer Schaltwandleranordnung mit zwei elektronischen Schaltern den folgenden Vorgang umfasst:
- Feststellen eines siebten Fehlerzustands, wenn bei geöffnetem ersten elektronischen Schalter und geschlossenem zweiten elektronischen Schalter und gemessener Spannung am Schaltausgang des ersten elektronischen Schalters und gemessener Spannung am Schaltausgang des zweiten elektronischen Schalters eine Spannung am Schaltausgang des ersten elektronischen Schalters ermittelt wird, die einen vorbestimmten sechsten Schwellwert nicht übersteigt und eine Spannung am Schaltausgang des zweiten elektronischen Schalters ermittelt wird, die den sechsten Schwellwert übersteigt.
